# EUROPEAN PATENT APPLICATION

(11) **EP 4 219 063 A1**
(43) Date of publication of application: **02.08.2023**
(21) Application number: 21872536.4
(22) Date of filing: 24.09.2021
(51) Int. Cl.: B23K 26/0622, B23K 26/38, H01S 3/00, H01S 3/067, H01S 3/102

(54) **LASER PROCESSING METHOD AND LASER PROCESSING APPARATUS**

(30) Priority: 25.09.2020 JP 2020161473
(71) Applicant: FURUKAWA ELECTRIC CO., LTD., Chiyoda-ku Tokyo 100-8322 (JP)
(72) Inventor: OGINO, Atsushi, Tokyo 100-8322 (JP); TAMURA, Ryosuke, Tokyo 100-8322 (JP); KASHIWAGI, Kousuke, Tokyo 100-8322 (JP); YOSHIHARA, Masakazu, Tokyo 100-8322 (JP); TOMINAGA, Keisuke, Tokyo 100-8322 (JP); KAYAHARA, Takashi, Tokyo 100-8322 (JP); MATSUNAGA, Keigo, Tokyo 100-8322 (JP)
(74) Representative: SSM Sandmair
(86) International application number: PCT/JP2021/034982
(87) International publication number: WO 2022/065407

(57) **Abstract**

A method of laser processing a workpiece made of at least one sheet of metallic foil, the method including a step of supplying pumping energy to a laser medium and generating laser light, the pumping energy being pulsed, and a step of irradiating a surface of the workpiece with the laser light; the laser light includes an optical pulse component and a continuous light component continuous with the optical pulse component, the continuous light component being temporally after the optical pulse component; and the method further includes a step of limiting duration of the continuous light component so that a ratio of energy of the continuous light component to energy of the optical pulse component becomes equal to or less than a predetermined value.

## Description

### Field

The present invention relates to laser processing methods and laser processing apparatuses.

### Background

In a method disclosed as a method of processing a workpiece by using a fiber laser apparatus, the rate of absorption of laser light is increased by increase in temperature of the workpiece through irradiation of the workpiece with a giant pulse and the workpiece is processed by irradiation of the workpiece with laser light of steady output after generation of the giant pulse (Patent Literature 1).

### Citation List

### Patent Literature

Patent Literature 1: Japanese Patent No. 6347676 Summary

### Technical Problem

However, in the method disclosed in Patent Literature 1, workpieces are processed by irradiation of the workpieces with laser light of steady output, and problems, such as dross and discoloration, may thus occur in the processed portion, for example, in a case where a workpiece formed of thin metallic foil is processed.

The present invention has been made in view of the above, and an object thereof is to provide a laser processing method and a laser processing apparatus that are suitable for processing of workpieces formed of metallic foil.

### Solution to Problem

TO solve the above-described problem and achieve the object, a laser processing method of laser processing a workpiece made of at least one sheet of metallic foil of one aspect of the present invention includes: a step of generating laser light by supplying pulsed pumping energy to a laser medium; and a step of irradiating a surface of the workpiece with the laser light, wherein the laser light includes an optical pulse component and a continuous light component that is continuous with the optical pulse component and temporally after the optical pulse component, and the laser processing method further includes a step of limiting duration of the continuous light component such that a ratio of energy of the continuous light component to energy of the optical pulse component is equal to or less than a predetermined value.

The ratio may be 40 or less.

The ratio may be 5 or less.

The laser light may have a time width of 12 µs or shorter.

The time width may be 2.3 µs or shorter.

A step of generating pumping light as the pumping energy by supplying pulsed electric power to a pumping light source may be included.

The electric power may have a rectangular pulse having a time width of 10 µs or shorter.

The electric power may have a rectangular pulse having a time width set at a shortest on time period or longer, and the shortest on time period may be a value that results in reduction of peak power of the optical pulse component when the time width is shorter than the shortest on time period.

The electric power may have a pulse repetition frequency of 5 kHz or higher.

The pulse repetition frequency of the electric power may be equal to or higher than 50 kHz and lower than 300 kHz.

A step of moving a position to be irradiated with the laser light on the surface of the workpiece relatively to the workpiece may be included.

A laser processing apparatus for laser processing of a workpiece of one aspect of the present invention includes: a laser device configured to generate laser light by supplying pulsed pumping energy to a laser medium; an optical head configured to emit the laser light onto a surface of the workpiece; and a control device configured to control the laser device, wherein the control device is configured to perform control of limiting duration of a continuous light component such that the laser light includes an optical pulse component and the continuous light component and a ratio of energy of the continuous light component to energy of the optical pulse component is equal to or less than a predetermined value, the optical pulse component being generated due to relaxation oscillation at beginning of generation of the laser light, the continuous light component being continuous with the optical pulse component and temporally after the optical pulse component.

### Advantageous Effects of Invention

The present invention enables provision of a laser processing method and a laser processing apparatus that are suitable for processing of workpieces formed of metallic foil.

### Brief Description of Drawings

FIG. 1 is a diagram of a schematic configuration of a laser processing apparatus according to a first embodiment.
FIG. 2 is a diagram of a schematic configuration of a laser device illustrated in FIG. 1.
FIG. 3 is a diagram of a schematic configuration of a drive unit illustrated in FIG. 2.
FIG. 4 is a diagram illustrating a waveform of one pulse of laser light.
FIG. 5 is an enlarged diagram of a part of the time range of FIG. 4.
FIG. 6 is a diagram for explanation of a time width of the laser light.
FIG. 7 is a diagram illustrating an example of relations between repetition frequency and shortest on time period.
FIG. 8 is a diagram of a schematic configuration of a laser processing apparatus according to a second embodiment.

### Description of Embodiments

Embodiments of the present invention will be described in detail hereinafter by reference to the drawings. The present invention is not limited by these embodiments. Furthermore, the same reference sign will be assigned to elements that are the same or corresponding to each other as appropriate throughout the drawings, and redundant explanation thereof will be omitted. Furthermore, in the drawings, directions may be indicated by use of an XYZ orthogonal coordinate system.

### First Embodiment

### Laser Processing Apparatus

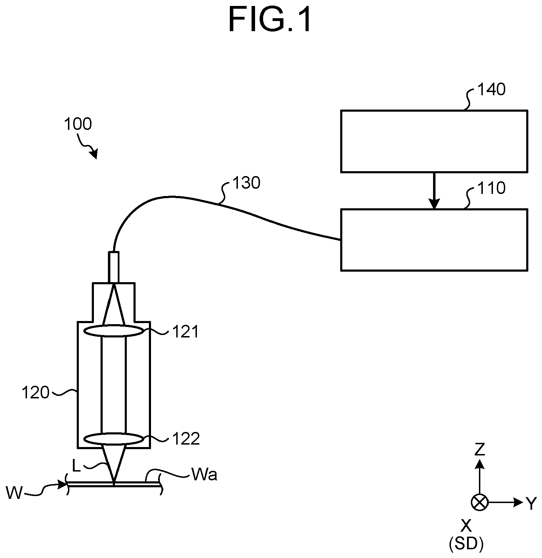

FIG. 1 is a diagram of a schematic configuration of a laser processing apparatus according to a first embodiment. This laser processing apparatus 100 includes a laser device 110, an optical head 120, an optical fiber 130 that connects the laser device 110 and the optical head 120 to each other, and a control device 140.

The laser processing apparatus 100 is an apparatus that implements laser cutting of laser processing, such as welding, drilling, and cutting.

A workpiece W for the laser processing apparatus 100 includes a metallic material. The metallic material is, for example: a copper-based material, such as copper or a copper alloy; or an aluminum-based material, such as aluminum or an aluminum alloy.

Furthermore, the workpiece W includes at least one sheet of metallic foil. For example, the workpiece W includes one sheet of metallic foil, or plural sheets of metallic foil that have been layered over one another. The metallic foil is, for example, an aluminum based rolled material having a thickness of 6 um to 200 µm, as prescribed by JIS H 4160, but the thickness is not limited to this example, and may be, for example, 500 um or smaller, or 250 um or smaller. The same applies to a case where the metallic foil includes another metallic material instead.

Furthermore, the workpiece W may be an electrode of a battery, such as a lithium-ion battery. In this case, the workpiece W may be coated with active materials, such as manganese dioxide and lithium. Furthermore, the workpiece W may be coated with a material different from the active materials, or may have a surface layer or coating, like a plated layer, formed on its entire surface or partly on its surface.

The laser device 110 is configured, for example, to output single mode laser light having power of a few kilowatts (kW). The laser device 110 will be described in detail later.

The optical fiber 130 guides laser light output from the laser device 110, to the optical head 120. In a case where the laser device 110 is to output single mode laser light, the optical fiber 130 is configured to propagate the single mode laser light therethrough. In this case, the beam quality factor M² of the single mode laser light is set at 1.2 or less. Furthermore, in a case where the laser device 110 is to output multimode laser light, the optical fiber 130 is configured to propagate the multimode laser light therethrough.

The optical head 120 is an optical device for irradiation of the workpiece W with laser light input from the laser device 110. The optical head 120 has a collimator lens 121 and a condenser lens 122. The optical head 120 may have any optical part other than the collimator lens 121 and the condenser lens 122.

The collimator lens 121 collimates laser light input thereto. The condenser lens 122 condenses the collimated laser light and outputs the condensed collimated laser light, as laser light L (output light), to the workpiece W.

The optical head 120 configured as described above emits the laser light L to a surface Wa of the workpiece W in a negative direction along a Z-axis.

A position irradiated with the laser light L is movable relatively to the workpiece W, the position being on the surface of the workpiece W. Such relative movement may be achieved by relative movement between the optical head 120 and the workpiece W through: movement of the optical head 120; movement of the workpiece W; or movement of both the optical head 120 and the workpiece W. For example, fixing the workpiece W and moving the optical head 120 in a positive direction along an X-axis sweep the position irradiated with the laser light L in a sweep direction SD in FIG. 1, the position being on the surface of the workpiece W. To enable such relative movement: the optical head 120 includes a movement mechanism that is movable along X and Y directions; or the workpiece W is supported by a stage that is capable of moving a workpiece in the X and Y directions.

However, in a case where drilling is performed as the laser processing, the above described relative movement is not necessarily required, and in cutting or welding also, relative movement may be not required for spot welding or cutting of thin metallic foil, for example.

The control device 140 controls actuation of the laser device 110, and actuation of the optical head 120 or a drive mechanism of the stage that supports the workpiece W. The control device 140 may, for example, include a personal computer and a peripheral device thereof.

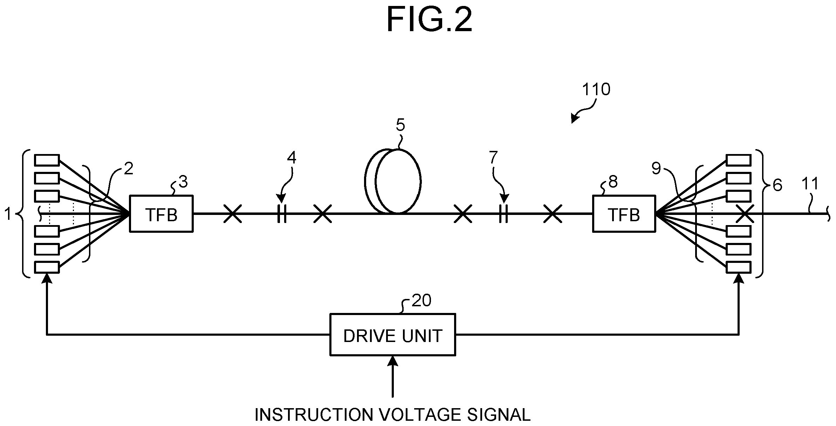

FIG. 2 is a diagram of a schematic configuration of the laser device 110 illustrated in FIG. 1. The laser device 110 is configured as a CW laser device capable of outputting continuous wave (CW) laser light. Therefore, a Q switch mechanism for outputting pulsed laser light may be not included.

The laser device 110 includes plural semiconductor pumping light sources 1 that are optical fiber lasers, plural optical fibers 2, an optical multiplexer 3, an optical fiber Bragg grating (FBG) 4, an optical amplifying fiber 5, an FBG 7, an optical multiplexer 8, plural optical fibers 9, plural semiconductor pumping light sources 6, an output optical fiber 11, and a drive unit 20. These elements are connected to each other by optical fibers, as appropriate. The output optical fiber 11 is optically coupled to the optical fiber 130 illustrated in FIG. 1 or is part (an input end) of the optical fiber 130. The semiconductor pumping light sources 1 and 6 are an example of pumping light sources and are configured as laser diode modules (LDMs) .

Each of the semiconductor pumping light sources 1 outputs pumping light to be supplied to the optical amplifying fiber 5. The optical amplifying fiber 5 is an example of a laser medium and the pumping light is an example of pumping energy. The pumping light has a wavelength that enables optical pumping in the optical amplifying fiber 5, for example, a wavelength of 915 nm. The plural optical fibers 2 respectively propagate the pumping light output from the semiconductor pumping light sources 1 and output the propagated pumping light to the optical multiplexer 3.

The optical multiplexer 3 includes a tapered fiber bundle (TFB) in this embodiment. The optical multiplexer 3 multiplexes the pumping light input from the optical fibers 2 to an optical fiber of its signal light port to output the multiplexed pumping light to the optical amplifying fiber 5.

The optical amplifying fiber 5 is an ytterbium doped fiber (YDF) having ytterbium (Yb) ions added to its core portion made of silica-based glass, the Yb ions being an amplifying material, and is a double cladding optical fiber having an inner cladding layer and an outer cladding layer sequentially formed around the core portion, the inner cladding layer being made of silica-based glass, the outer cladding layer being made of a resin, for example. The core portion of the optical amplifying fiber 5 is configured to: have an NA of, for example, 0.08; and cause single mode propagation of light emitted by the Yb ions therethrough, for example, light having a wavelength of 1070 nm. The core portion of the optical amplifying fiber 5 has an absorption coefficient of 200 dB/m at the wavelength of 915 nm, for example. Furthermore, the power conversion efficiency from the pumping light input to the core portion to oscillated laser light is, for example, 70%. However, the absorption coefficient and the power conversion efficiency are not limited to these examples.

The FBG 4 that is a back end reflecting means and is connected between the optical fiber of the signal light port of the optical multiplexer 3 and the optical amplifying fiber 5. The FBG 4 has a center wavelength of, for example, 1070 nm, and a reflectivity of about 100% at the center wavelength and in a wavelength bandwidth having a width of about 2 nm around the center wavelength; and transmits most of light having the wavelength of 915 nm therethrough. Furthermore, the FBG 7 that is an output end reflecting means is connected between an optical fiber of a signal light port of the optical multiplexer 8 and the optical amplifying fiber 5. The FBG 7 has: a center wavelength that is approximately the same as that of the FBG 4, for example, 1070 nm; a reflectivity of about 10% to about 30% at the center wavelength; and a full width at half maximum of about 1 nm in a reflection wavelength bandwidth, and transmits most of light having the wavelength of 915 nm therethrough.

The FBGs 4 and 7 are respectively arranged at two ends of the optical amplifying fiber 5 and form an optical fiber resonator for light having the wavelength of 1070 nm.

Each of the semiconductor pumping light sources 6 outputs pumping light to be supplied to the optical amplifying fiber 5. The pumping light has a wavelength that enables optical pumping in the optical amplifying fiber 5, for example, the wavelength of 915 nm. The plural optical fibers 9 respectively propagate the pumping light output from the semiconductor pumping light sources 6 and output the propagated pumping light to the optical multiplexer 8.

Similarly to the optical multiplexer 3, the optical multiplexer 8 in this embodiment includes a TFB. The optical multiplexer 8 multiplexes the pumping light input from the optical fibers 9 to the optical fiber of its signal light port to output the multiplexed pumping light to the optical amplifying fiber 5.

The Yb ions in the core portion of the optical amplifying fiber 5 are optically pumped by the pumping light and thereby emit light having a band including the wavelength of 1070 nm. The emission of light having the wavelength of 1070 nm causes laser oscillation by the optical amplifying function of the optical amplifying fiber 5 and the function of the optical resonator formed of the FBGs 4 and 7. The laser device 110 thereby generates laser light.

The output optical fiber 11 is arranged at an end opposite to the FBG 7, and is connected to the optical fiber of the signal light port of the optical multiplexer 8. The laser light oscillated (oscillated laser light) is output from the output optical fiber 11.

The drive unit 20 supplies, according to an instruction voltage signal input from the control device 140, driving current to the semiconductor pumping light sources 1 and 6.

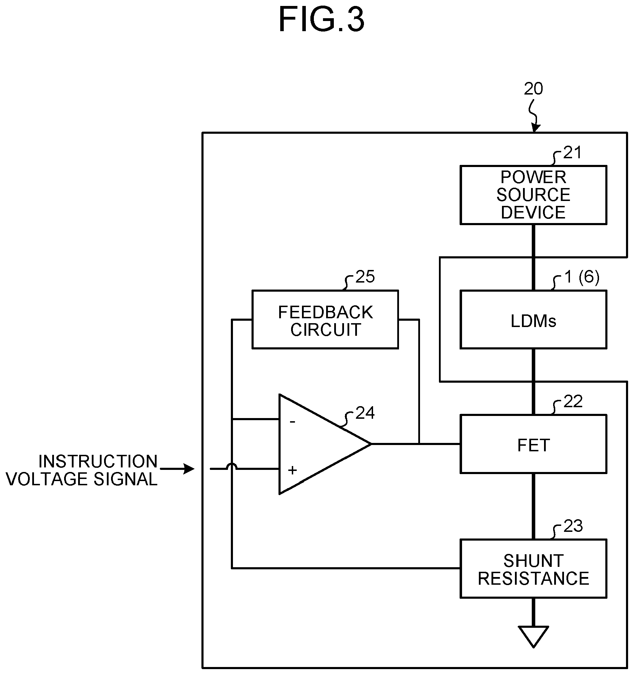

FIG. 3 is a diagram of a schematic configuration of the drive unit illustrated in FIG. 2. The drive unit 20 is mainly formed of analog circuitry, and includes a power source device 21, a field-effect transistor (FET) 22, shunt resistance 23, an operational amplifier 24, and a feedback circuit 25.

The power source device 21 is a publicly known direct-current power source connected to supply electric current to the semiconductor pumping light sources 1 and 6. For example, the semiconductor pumping light sources 1 are connected in series, and the semiconductor pumping light sources 6 are connected in series, separately from the semiconductor pumping light sources 1. Furthermore, all of the semiconductor pumping light sources 1 and the semiconductor pumping light sources 6 may be connected in series.

The FET 22 is connected downstream from the semiconductor pumping light sources 1 and 6, on a power source line extending from the power source device 21 to a ground. The FET 22 adjusts, according to gate voltage applied to the FET 22, the amounts of electric current supplied to the semiconductor pumping light sources 1 and 6 via the power source line from the power source device 21.

The shunt resistance 23 is connected downstream from the FET 22, on the power source line. The shunt resistance 23 has a function of taking out, as a voltage value, information on an amount of electric current flowing through the power source line.

The operational amplifier 24 has a non-inverting input where an instruction voltage signal is input, an inverting input where the voltage value from the shunt resistance 23 is input, and an output connected to a gate of the FET 22.

The feedback circuit 25 is configured as an integrating circuit including a capacitor and forms a feedback route from the output of the operational amplifier 24 to the inverting input of the operational amplifier 24.

The drive unit 20 configured as described above is capable of executing constant current control of supplying a constant current to the semiconductor pumping light sources 1 and 6. The constant current is an electric current value corresponding to a voltage level of an instruction voltage signal.

### Laser Processing Method

An example of a laser processing method using the laser processing apparatus 100 will be described next for a case of laser cutting, for example.

Firstly, a step of supplying pumping energy that is pulsed, to the laser medium to generate laser light is executed at the laser processing apparatus 100. Specifically, first, the control device 140 executes a step of outputting a pulsed instruction voltage signal having a predetermined repetition period to the drive unit 20 of the laser device 110. The drive unit 20 thereby executes a step of supplying pulsed driving power (driving current) to the semiconductor pumping light sources 1 and 6 to generate pumping energy that is pulsed pumping light. The driving power has, for example, a rectangular pulse. Thereafter, the semiconductor pumping light sources 1 and 6 in the laser device 110 supply the pulsed pumping light to the optical amplifying fiber 5 to generate pulsed laser light having a predetermined repetition period.

Thereafter, the optical head 120 where the laser light has been input executes a step of emitting the laser light L to the surface Wa of the workpiece W and a step of moving a position irradiated with the laser light L relatively to the workpiece W, the position being on the surface Wa of the workpiece W. The step of moving the position irradiated with the laser light L relatively to the workpiece W may be executed by the control device 140 driving the stage that supports the workpiece W. Laser cutting of the workpiece W is thereby executed.

In this laser cutting, the laser light L includes an optical pulse component generated due to relaxation oscillation at the beginning of generation of the laser light L and a continuous light component that is continuous with the optical pulse component and temporally after the optical pulse component. In a case where, for example, the ratio of energy of the continuous light component in the laser light L to energy of the optical pulse component in the laser light L is equal to or less than a predetermined value, or in a case where, additionally, the time width of the laser light L is equal to or shorter than a predetermined value, laser cutting with reduced dross and discoloration is able to be executed. The energy ratio and the time width may be achieved by the control device 140 controlling the laser device 110.

As described above, by executing the step of supplying pulsed pumping energy to the laser medium to generate laser light, the laser device 110 is able to generate an optical pulse component through drive control using a general-purpose control circuit, for example, without having a Q switch mechanism. The inventors found out that because this optical pulse component is an edgy peak generated due to relaxation oscillation, the optical pulse component is able to be applied to processing of metallic foil, which had been considered to be difficult. Furthermore, the inventors have also found out that if the power or energy of the continuous light component following the optical pulse component is too high, the amount of heat input to the metallic foil becomes excessive and this is actually unfavorable for the processing of metallic foil. Therefore, the inventors have devised a technological idea of implementing preferred metallic foil processing by adjustment of the amount of heat input, through control of limiting the duration of the continuous light component so that the ratio of the energy of the continuous light component to the energy of the optical pulse component becomes equal to or less than the predetermined value. Furthermore, the inventors have also found out that the energy ratio is able to be desirably adjusted readily by adjustment of a pulse width of pulsed electric power supplied to the semiconductor pumping light sources 1 and 6.

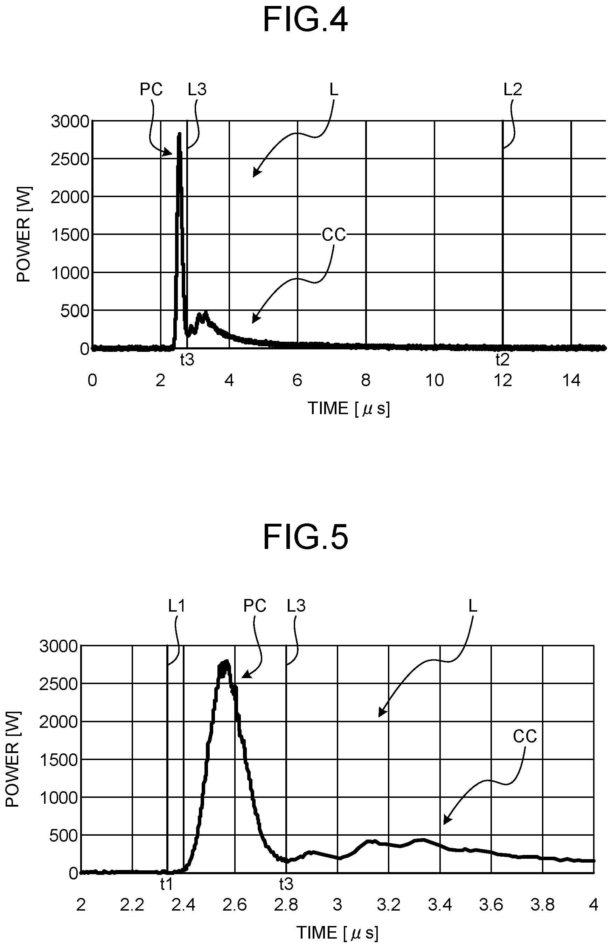

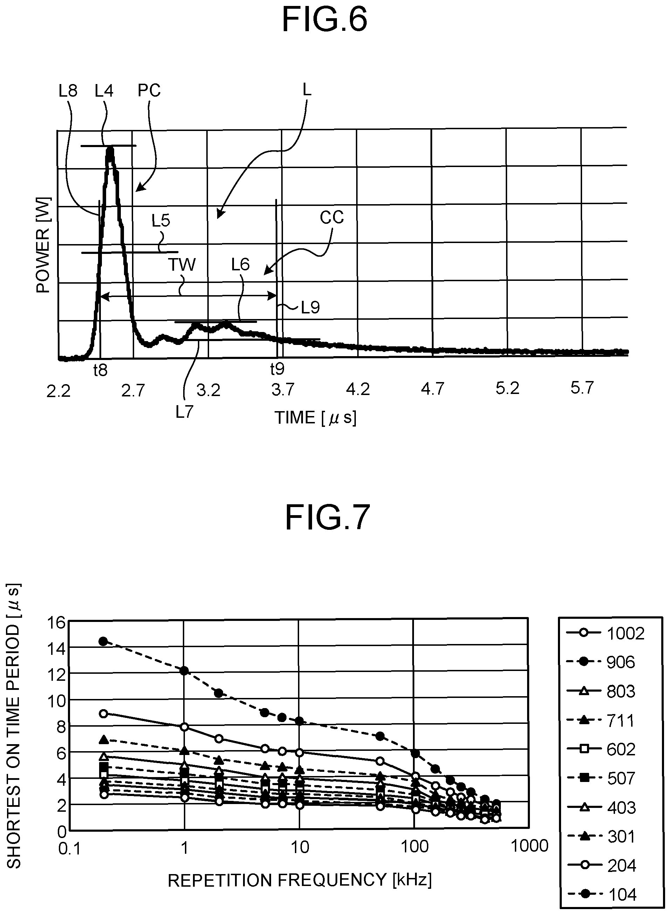

The energy ratio is, for example, 40 or less and the time width of the laser light L is, for example, 12 µs or shorter. Furthermore, the duration of the continuous light component is, for example, defined as a time period from time t3 to time t9 in FIG. 5 and FIG. 6 described later, but is not particularly limited as long as the duration of the continuous light component is defined to represent a time length in which the continuous light component has power.

A more detailed description will be made hereinafter by use of a waveform along a time axis of laser light and an experimental example. FIG. 4 is a diagram illustrating a waveform of one pulse of the laser light L. FIG. 5 is an enlarged diagram of a part of the time range of FIG. 4. In FIG. 4 and FIG. 5, the horizontal axes correspond to time in microseconds (µs) and the vertical axes correspond to power in watts (W). The time on the horizontal axes indicates the time where predetermined time before generation of the one pulse of the laser light L is 0 us. As illustrated in FIG. 4, the laser light L includes, in the one pulse, an optical pulse component PC and a continuous light component CC.

In the laser device 110, by supply of pumping light to the optical amplifying fiber 5 from the semiconductor pumping light sources 1 and 6, the pumping light being pulsed, the optical pulse component PC resulting from relaxation oscillation is generated according to the shape of a rise of the pumping light. The optical pulse component PC has an edgy peak shape high in power and short in pulse width. Thereafter, the continuous light component CC that is continuous with the optical pulse component PC, temporally after the optical pulse component PC, and temporally continuous is generated, but the power of this continuous light component CC decreases early due to a fall of the pumping light. A line L1 indicates the position of time t1 before the optical pulse component PC is generated, a line L2 indicates the position of time t2 after the continuous light component CC has attenuated, and the power of the light is 0 W at both the time t1 and the time t2.

A line L3 indicates the position of time t3 at which the power of the optical pulse component PC in the laser light L has a local minimum value for the first time after the power has reached the peak. In this specification, the position of such a local minimum value is defined as the boundary between the optical pulse component PC and the continuous light component CC. In FIG. 4, a vibrational component smaller in power than the optical pulse component PC is generated also after the time t3, but this vibrational component is included in the continuous light component CC according to this specification. Therefore, the energy of the optical pulse component PC is obtained by time integration of the power of the optical pulse component PC in a range of, for example, the time t1 to the time t3. The energy is in units of, for example, joules. Furthermore, the energy of the continuous light component CC is obtained by time integration of the power of the continuous light component CC in a range of the time t3 to the time t2. The time t1 may have any value at which the power of the optical pulse component PC is 0 W, without being limited to this value, and the time t2 may have any value at which the power of the continuous light component CC is 0 W, without being limited to this value.

Furthermore, in this embodiment, the laser light L has the time width of 12 µs or shorter. FIG. 6 is a diagram for explanation of the time width of the laser light. A line L4 indicates the power level of the peak of the optical pulse component PC and a line L5 indicates the power level that is 50% of the peak. Furthermore, a line L6 indicates the power level of the maximum value of the continuous light component CC and a line L7 indicates the power level that is 50% of the maximum value. In this specification, a time width TW of laser light is defined as a time width from time t8 (indicated by a line L8) at which the power level becomes 50% of the peak on the rise of the optical pulse component PC to time t9 (indicated by a line L9) at which the power level becomes 50% of the maximum value on the fall of the continuous light component CC.

In this embodiment, the energy ratio of the energy of the continuous light component CC to the energy of the optical pulse component PC is, for example, 40 or less and the time width TW of the laser light L is, for example, 12 µs or shorter. The workpiece W that is made of metallic foil and thin is thereby able to be processed by use of the optical pulse component PC high in power and short in pulse width and excessive heat input to the workpiece W due to the continuous light component CC is thereby able to be minimized by appropriate reduction of the continuous light component CC. As a result, problems such as dross and discoloration that occur in the processed portion are able to be reduced.

Furthermore, in a case where the energy ratio is 5 or less or in a case where the time width TW is 2.3 µs or shorter, the heat input due to the continuous light component CC is minimized further, and those problems caused by the heat input are thus able to be reduced further.

Values of the energy ratio and the time width TW may be set as appropriate according to, for example, characteristics of the workpiece W, for example, the material and thickness of the metallic foil and the number of sheets of the metallic foil.

The waveform and power of the laser light L change dependently on the waveform of the pulse of the pumping light output by the semiconductor pumping light sources 1 and 6. The waveform of the pulse of the pumping light changes dependently on the waveform of the pulse of the driving power from the drive unit 20. Furthermore, the waveform of the pulse of the driving power is able to be controlled by the waveform of the pulse of an instruction voltage signal from the control device 140. Therefore, the waveform and power of the laser light L are able to be controlled by change of the waveform of the pulse of the instruction voltage signal from the control device 140.

Furthermore, the repetition frequency of the pulse of the driving power is not particularly limited, but is, for example, 5 kHz or higher. The repetition frequency of 5 kHz or higher facilitates obtainment of a preferred waveform of the laser light L, the preferred waveform having the above described energy ratio of 40 or less and time width TW of 12 µs or shorter. The on time period of the pulse of the driving power is the time width of the pulse of the driving power.

Furthermore, when the time width of the pulse of the driving power is short to some degree, the time width is suitable for decreasing the energy of the continuous light component CC, but according to diligent studies made by the inventors, when the time width is too short, the peak power of the optical pulse component PC is reduced. Therefore, for efficient utilization of the energy of the optical pulse component PC to laser processing, the time width is preferably short to an extent where the peak power of the optical pulse component PC is not reduced. In this specification, the shortest on time period is thus prescribed as an index of the time width of the pulse of the driving power. The shortest on time period is a value that results in reduction of the peak power of the optical pulse component when the time width of the pulse of the driving power is shorter than the shortest on time period. In this case, if the time width of the pulse of the electric power is set at the shortest on time period or longer, the energy of the optical pulse component PC is able to be utilized efficiently for laser processing.

FIG. 7 is a diagram illustrating relations between repetition frequency and the shortest on time period in a laser device having a configuration that is the same as that of the laser device 110 according to the first embodiment. The horizontal axis corresponds to repetition frequency of the pulse of the driving power and the vertical axis corresponds to the shortest on time period. Furthermore, the numerical values from "104" to "1002" in the legend indicate values of average power (W) in a steady state at instruction values set for the laser device 110. The instruction values herein refer to voltage values of instruction voltage signals. The laser device 110 is configured to have a rated laser output of 1000 W.

As illustrated in FIG. 7, as the repetition frequency decreases, the shortest on time period increases. Furthermore, the shortest on time period increases as the average power decreases. To make the time width TW 12 us or shorter for the waveform of the laser light L, the on time period of the pulse of the driving power is preferably about 10 µs or shorter. In this case, when the repetition frequency is 5 kHz or higher, the on time period is able to be set at the shortest on time period at various values of the average power.

The laser device 110 is configured as a CW laser device but is capable of generating the optical pulse component PC having an edgy peak by utilization of relaxation oscillation, and is thus able to be configured more uncomplicatedly and at lower cost than a pulse laser device having a Q switch mechanism.

### Processing Experiments

A laser processing apparatus having the same configuration as the laser processing apparatus 100 according to the first embodiment was manufactured and experiments were performed, the experiments each being an experiment in which a workpiece made of metallic foil was cut. The workpiece was a sheet of copper foil having a thickness of 8 um. The driving power was set so that the average power became 1000 W in a steady state at each instruction value. The repetition frequency of the pulse of the driving power was set at various values between a value lower than 5 kHz and 300 kHz. Furthermore, the on time period of the pulse of the driving power was set at various values between 0.5 µs to 100 µs.

Table 1 shows results of the processing. The processing quality was ranked according to predetermined evaluation criteria by check of outer appearances by use of a microscope, in terms of dross and discoloration (due to production of oxidized portions). Unacceptable quality with dross large in size was evaluated as "poor", acceptable quality with dross small in size and oxidized portions large in size as "good", a rank higher in quality with dross small in size and oxidized portions moderate in size as "very good", and a rank highest in quality with dross and oxidized portions small in size as "excellent". Furthermore, "-" corresponds to a condition for which no experiment has been done. As shown in Table 1, when the energy ratio R was 40 or less and the time width TW of laser light was 12 µs or shorter, results ranked as "good" or "very good" were obtained; and when the energy ratio R was 5 or less and the time width TW of laser light was 2.3 µs or shorter, results ranked as "very good" or "excellent" were obtained. In particular, when the repetition frequency was 5 kHz or higher and 50 kHz or lower: in cases where time widths TW of laser light were longer than 2.3 µs and 12 us or shorter, results ranked as "good" were obtained; and in cases where the time widths TW were longer than 0.1 µs and 2.3 µs or shorter, results ranked as "very good" were obtained. Furthermore, when the repetition frequency was equal to or higher than 50 kHz and lower than 300 kHz: in cases where the time widths TW of laser light were longer than 2.3 µs and 12 us or shorter, results ranked as "very good" were obtained; and in cases where the time widths TW were longer than 0.1 µs and equal to or shorter than 2.3 µs, results ranked as "excellent" were obtained.

**Table 1**

| Time width of driving power (µs) | Time width TW of laser light (µs) | Energy ratio R | Repetition frequency (kHz) | | |
|---|---|---|---|---|---|
| | | | Less than 5 | 5 to 50 | 50 to 300 |
| 0.5 to 3 | 0.1 < TW <_ 2.3 | 0.1 < R ≤ 5 | - | Very good | Excellent |
| 3 to 15 | 2.3 < TW ≤ 12 | 5 < R ≤ 40 | - | Good | Very good |
| 15 to 100 | 12 < TW <_ 99 | 40 < R ≤ 250 | Poor | Poor | Poor |

### Second Embodiment

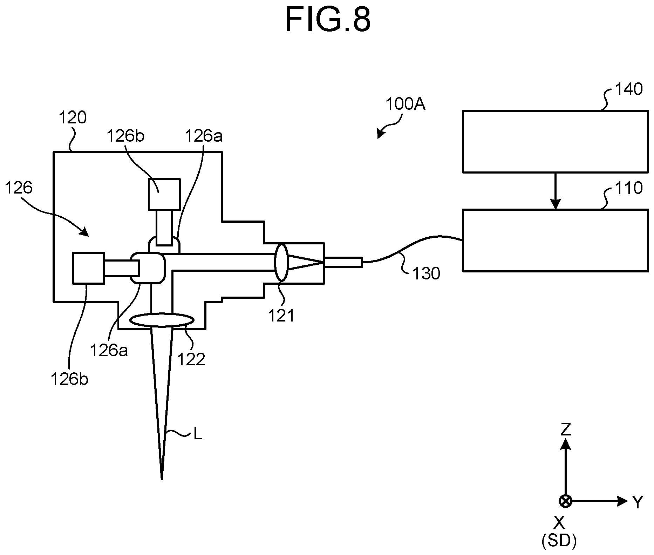

FIG. 8 is a diagram of a schematic configuration of a laser processing apparatus according to a second embodiment. In this embodiment, an optical head 120 has a galvanoscanner 126 between a collimator lens 121 and a condenser lens 122. The galvanoscanner 126 has two mirrors 126a. Changing postures of these two mirrors 126a changes the direction in which laser light L is emitted and the position irradiated with the laser light L. That is, without movement of the optical head 120, a laser processing apparatus 100A enables sweep of the laser light L by movement of the position irradiated with the laser light L. The control device 140 is capable of controlling actuation of motors 126b respectively corresponding to the mirrors 126a so that the angles (postures) of the mirrors 126a are changed. This embodiment also achieves functions and effects similar to those of the first embodiment.

In each of the above described embodiments, the optical amplifying fiber 5 is a YDF but the optical amplifying fiber 5 may instead be an optical amplifying fiber having another rare earth element, such as erbium or neodymium, added therein as an amplifying medium. In this case, the pumping light and laser light generated have wavelengths according to the type of the amplifying medium.

Furthermore, in each of the above described embodiments, the laser device 110 is an optical fiber laser, but the laser device 110 may instead be a laser device using a laser of another type, such as a semiconductor laser or a solid-state laser.

Furthermore, in each of the above described embodiments, the pulse of the driving power is rectangular, but is not necessarily rectangular as long as the pulse enables generation of laser light having a ratio that is 40 or less and a time width that is 12 µs or shorter, the ratio being of energy of the continuous light component in the laser light to energy of the optical pulse component in the laser light. The shape of the pulse of the pumping light is similarly not limited.

Furthermore, the present invention is not limited by the above described embodiments. Those configured by combination of the components described above as appropriate are also included in the present invention. In addition, further effects and modifications can be easily derived by those skilled in the art. Therefore, wider aspects of the present invention are not limited to the above described embodiments, and various modifications are possible.

### Industrial Applicability

As described above, the present invention is suitable for use in laser processing methods and laser processing apparatuses.

### Reference Signs List

- 1, 6: SEMICONDUCTOR PUMPING LIGHT SOURCE
- 2, 9, 130: OPTICAL FIBER
- 3, 8: OPTICAL MULTIPLEXER
- 5: OPTICAL AMPLIFYING FIBER
- 11: OUTPUT OPTICAL FIBER
- 20: DRIVE UNIT
- 21: POWER SOURCE DEVICE
- 22: FET
- 23: SHUNT RESISTANCE
- 24: OPERATIONAL AMPLIFIER
- 25: FEEDBACK CIRCUIT
- 100, 100A: LASER PROCESSING APPARATUS
- 110: LASER DEVICE
- 120: OPTICAL HEAD
- 121: COLLIMATOR LENS
- 122: CONDENSER LENS
- 126: GALVANOSCANNER
- 126a: MIRROR
- 126b: MOTOR
- 140: CONTROL DEVICE
- CC: CONTINUOUS LIGHT COMPONENT
- L: LASER LIGHT
- PC: OPTICAL PULSE COMPONENT
- SD: SWEEP DIRECTION
- TW: TIME WIDTH
- W: WORKPIECE
- Wa: SURFACE

## Claims

1. A laser processing method of laser processing a workpiece made of at least one sheet of metallic foil, the laser processing method comprising:
a step of generating laser light by supplying pulsed pumping energy to a laser medium; and
a step of irradiating a surface of the workpiece with the laser light, wherein
the laser light includes an optical pulse component and a continuous light component that is continuous with the optical pulse component and temporally after the optical pulse component, and
the laser processing method further comprises a step of limiting duration of the continuous light component such that a ratio of energy of the continuous light component to energy of the optical pulse component is equal to or less than a predetermined value.

2. The laser processing method according to claim 1, wherein the ratio is 40 or less.

3. The laser processing method according to claim 2, wherein the ratio is 5 or less.

4. The laser processing method according to any one of claims 1 to 3, wherein the laser light has a time width of 12 µs or shorter.

5. The laser processing method according to claim 4, wherein the time width is 2.3 µs or shorter.

6. The laser processing method according to any one of claims 1 to 5, further comprising a step of generating pumping light as the pumping energy by supplying pulsed electric power to a pumping light source.

7. The laser processing method according to claim 6, wherein the electric power has a rectangular pulse having a time width of 10 µs or shorter.

8. The laser processing method according to claim 6 or 7, wherein
the electric power has a rectangular pulse having a time width set at a shortest on time period or longer, and
the shortest on time period is a value that results in reduction of peak power of the optical pulse component when the time width is shorter than the shortest on time period.

9. The laser processing method according to any one of claims 6 to 8, wherein the electric power has a pulse repetition frequency of 5 kHz or higher.

10. The laser processing method according to claim 9, wherein the pulse repetition frequency of the electric power is equal to or higher than 50 kHz and lower than 300 kHz.

11. The laser processing method according to any one of claims 1 to 10, further comprising a step of moving a position to be irradiated with the laser light on the surface of the workpiece relatively to the workpiece.

12. A laser processing apparatus for laser processing of a workpiece, the laser processing apparatus comprising:
a laser device configured to generate laser light by supplying pulsed pumping energy to a laser medium;
an optical head configured to emit the laser light onto a surface of the workpiece; and
a control device configured to control the laser device, wherein
the control device is configured to perform control of limiting duration of a continuous light component such that the laser light includes an optical pulse component and the continuous light component and a ratio of energy of the continuous light component to energy of the optical pulse component is equal to or less than a predetermined value, the optical pulse component being generated due to relaxation oscillation at beginning of generation of the laser light, the continuous light component being continuous with the optical pulse component and temporally after the optical pulse component.
